# EUROPÄISCHE PATENTSCHRIFT

(11) **EP 4 222 802 B1**
(45) Veröffentlichungstag und Bekanntmachung des Hinweises auf die Patenterteilung: **16.04.2025**
(21) Anmeldenummer: 21789604.2
(22) Anmeldetag: 30.09.2021
(51) Int. Cl.: H01M 10/42

(54) **VORRICHTUNG ZUM TESTEN ZUMINDEST EINER BATTERIEZELLE**
DEVICE FOR TESTING AT LEAST ONE BATTERY CELL
DISPOSITIF DE TEST D'AU MOINS UNE CELLULE DE BATTERIE

(30) Priorität: 01.10.2020 AT 508412020
(43) Veröffentlichungstag der Anmeldung: 09.08.2023
(73) Patentinhaber: AVL List GmbH, 8020 Graz (AT)
(72) Erfinder: GILLI, Augustin, 8010 Graz (AT); PEER, Markus, 8041 Graz (AT); SCHWAB, Martin, 8010 Graz (AT)
(74) Vertreter: Babeluk Patentanwälte GmbH
(86) Internationale Anmeldenummer: PCT/AT2021/060352
(87) Internationale Veröffentlichungsnummer: WO 2022/067366

(56) Entgegenhaltungen:
- EP-A1- 3 621 128
- US-A1- 2020 132 577

## Beschreibung

Die Erfindung betrifft eine Vorrichtung zum Testen zumindest einer Batteriezelle, insbesondere einer Sekundärbatterie, mit einer ersten Platte und einer zweiten Platte, wobei die Batteriezelle zwischen den beiden im Wesentlichen rechteckigen Platten eingespannt ist und zumindest eine Platte mit einer definierten mechanischen Anpresskraft gegen die Batteriezelle gepresst ist, mit zumindest einem zwischen einer Platte und einer Anpressvorrichtung angeordneten Kraftmesselement zur Messung einer Reaktionskraft zwischen der Batteriezelle und der Anpressvorrichtung, wobei mittels zumindest eines Wegmesselements - vorzugsweise gleichzeitig mit der Reaktionskraft - die Änderung der Dicke der Batteriezelle messbar ist. Weiters betrifft die Erfindung ein Verfahren zum Testen zumindest einer Batteriezelle, insbesondere einer Sekundärbatterie, mit dieser Vorrichtung.

"Im Wesentlichen rechteckig" bedeutet hier, dass die Platten im Grundriss jeweils die Form eines Rechteckes mit zwei Paaren von parallelen Kanten aufweisen, wobei die Ecken des Rechteckes auch abgerundet sein können.

Die Charakterisierung von Batteriezellen bezüglich ihrer chemischen und physikalischen Eigenschaften ist ein notwendiger Entwicklungsschritt für das Design eines Batteriepacks.

Die Energiespeicherfähigkeit einer Batteriezelle hängt stark von der herangezogenen Zellenchemie ab. Neben der Zellenchemie haben auch äußere Einflüsse, wie beispielsweise die Einbausituation im Batterieverbund Auswirkung auf die Performanz einer Batteriezelle. So können Batteriezellen "schwimmend" (zwischen den Batteriezellen werden elastische Kunststoffkomponenten positioniert) oder "starr" (Zelle an Zelle) zum Batteriepack verbunden werden.

Batteriezellen haben die Eigenschaft, dass sich beim elektrischen Laden bzw. Entladen ihre äußeren Abmessungen, insbesondere ihre Dicke, ändern. Dieser Effekt ist auch als sogenannter Breathing und/oder Swelling-Effekt bekannt. Unter "Breathing" wird eine zyklische reversible Volumenzunahme und -abnahme bei Lade- und Entladevorgängen der Batterie bezeichnet. Mit "Swelling" wird eine beispielsweise alterungsbedingte irreversible Volumenzunahme bezeichnet. Weiters besteht auch ein Zusammenhang zwischen dem Zellenoberflächendruck und der Speicherfähigkeit der Zelle.

Das Testen von Batteriezellen unterschiedlicher Typen (Pouchzellen, prismatische Zellen) wird meist zwischen zwei fix verspannten Metallplatten durchgeführt.

So wird beispielsweise eine Pouchzelle im Bereich des Zellkörpers-zwischen zwei Metallplatten geklemmt und anschließend durch Schraubverbindung und einem errechneten Drehmoment, auf einen gewünschten Oberflächendruck verspannt. Die Zellenableiter bleiben dabei für die Kontaktierung der Bestromung frei zugänglich.

Lediglich die Steifigkeit der Spannplatten sowie das Drehmoment können in diesem Testaufbau angepasst werden.

Aus der DE 2018 123 626 A1ist eine Batterietemperiereinrichtung mit einer ersten Platte zum Auflegen einer Batteriezelle und einer zweiten Platte zum Andrücken der Batteriezelle auf die erste Platte bekannt. Zur Temperierung der Batteriezelle ist eine Heizvorrichtung/Kühlvorrichtung vorgesehen. Mittels einer Vorrichtung zum Verspannen kann die zweite Platte mit einer definierten Anpresskraft gegen die erste Platte gedrückt werden, wobei zwischen der Vorrichtung zum Verspannen und der ersten Platte eine Kraftmessdose angeordnet ist.

Die US 2020/132577 A1 offenbart eine Vorrichtung zur Messung einer Batteriezelle mit einem an jeder Ecke einer Platte und einer Anpressvorrichtung angeordneten Anpressvorrichtung angeordnetem Kraftmesselement zur Messung einer Reaktionskraft zwischen der Batteriezelle und der Anpressvorrichtung, wobei die Vorrichtung ferner ein Dehnmesselement umfasst, mit dem während eines Lade-Entladezyklus in Echtzeit gleichzeitig die Reaktionskraft und die Dicke der Batteriezelle messbar ist.

Die Veröffentlichung EP 3 621 128 A1 offenbart ein Batteriepaket mit einem Batteriemodul und einem Drucksensorapparat zur Messung einer Expansionskraft. Ein Wegmesselement ist nicht vorgesehen.

Weiters sind Vorrichtungen zum Messen der Zellausdehnung einer Batteriezelle bekannt, beispielsweise aus den Dokumenten EP 3 377 363 A1, US 2015/188198 A1, US 2014/311223 A1, US 2014/107949 A1 oder US 2013/323554 A1.

Die aus dem Stand der Technik bekannten Vorrichtungen haben alle die Eigenschaft, dass Oberflächendruck und Ausdehnung der Batteriezelle nicht gleichzeitig gemessen werden können.

Aufgabe der Erfindung ist es, die Genauigkeit und die Aussagekraft von Tests von Batteriezellen zu erhöhen.

Erfindungsgemäß wird die Lösung der gestellten Aufgabe bei einer Vorrichtung der eingangs genannten Art dadurch gelöst, dass zumindest eine Platte, vorzugsweise die erste Platte, zumindest ein thermisches Messelement zur Messung der Zellkörpertemperatur der Batteriezelle aufweist, und dass zumindest eine Platte, vorzugsweise die zweite Platte, zumindest ein Kontaktelement aufweist, welches eine elektrische Verbindung zwischen zumindest einem Zellpol und einem vorzugsweise flexiblen Stromkabel herstellt, wobei in zumindest ein Kontaktelement ein Temperatursensor integriert ist.

Somit können die Reaktionskraft und die Änderung der Dicke der Batteriezelle zugleich gemessen werden.

Dadurch, dass zumindest eine Platte zumindest ein thermisches Messelement aufweist, welches günstigerweise den Zellkörper kontaktiert, kann eine genaue Erfassung der Zellkörpertemperatur der Batteriezelle ermöglicht werden. Auf diese Weise kann eine einfache und exakte Überwachung der Oberflächentemperatur des Zellkörpers durchgeführt werden.

Durch die Integrierung der elektrische Ableiter bildenden Kontaktelemente in die zweite Platte wird beim Aufsetzen der zweiten Platte auf die Batteriezelle gleichzeitig mit dem Komprimieren der Batteriezelle eine elektrische Verbindung des Stromkabels zu den Zellpolen hergestellt. Dies ermöglicht ein schnelles Wechseln und erneutes elektrisches Kontaktieren der Batteriezellen.

Dadurch, dass in zumindest ein Kontaktelement ein Temperatursensor integriert ist, kann die Temperatur der Zellpole bei Lade- und Entladevorgängen laufend gemessen werden.

Die Reaktionskraft wird nicht vollständig durch die Anpressvorrichtung als Vorspannung aufgeprägt, sondern setzt sich aus der anfangs aufgeprägten Anpresskraft und aus der beim Test resultierenden Betriebskraft der Batteriezelle, die sich durch chemische Prozesse im Inneren des Zellkörpers bildet, zusammen.

Das Kraftmesselement und das Wegmesselement sind dabei bevorzugt durch separate und/oder räumlich getrennte Bauteile gebildet, wodurch Kraft- und Wegmessungen vollkommen unabhängig voneinander durchgeführt werden können. Beispielsweise können das Kraftmesselement und das Wegmesselement an verschiedenen Stellen der Vorrichtung angeordnet sein. Eine gegenseitige Beeinflussung der Messergebnisse wird dadurch weitgehend vermieden.

Eine einfache und genaue Wegmessung ist möglich, wenn zumindest ein Wegmesselement im Bereich einer Längsmittelebene und/oder einer Längsquerebene der Zelle und/oder zumindest einer Platte angeordnet ist. Die Längsmittelebene und die Längsquerebene, die sich parallel zur Richtung der Anpresskraft bzw. Reaktionskraft erstrecken, verlaufen dabei bevorzugt durch den Schwerpunkt der Zelle und/oder durch den Flächenschwerpunkt der ersten und/oder zweiten Platte.

Eine genaue Wegmessung mit einem einzigen Wegmesselement ist möglich, wenn das Wegmesselement im Bereich einer Verschneidungslinie zwischen der Längsmittelebene und der Quermittelebene angeordnet ist.

In einer Ausführungsvariante der Erfindung ist vorgesehen, dass die erste Platte und die zweite Platte durch zumindest eine Anpressvorrichtung miteinander verbunden sind, wobei vorzugsweise die Anpressvorrichtung im Bereich einer Ecke der ersten und zweiten Platte angeordnet ist.

Vorzugsweise ist im Bereich zumindest zweier Ecken zumindest einer Platte, insbesondere an jeder Ecke zumindest einer Platte, jeweils ein Kraftmesselement zwischen der Platte und einer Anpressvorrichtung angeordnet.

Eine erfindungsgemäße Ausführungsvariante sieht vor, dass zumindest ein Kraftmesselement als Kraftmessring ausgebildet ist, wobei vorzugsweise der Kraftmessring von einem bolzen- oder hülsenförmigen Abschnitt der Anpressvorrichtung durchsetzt ist.

Eine einfache und genaue Kraftmessung kann erreicht werden, wenn zumindest ein Kraftmesselement als DMS-Sensor ausgebildet ist. Als DMS-Sensoren (DMS=Dehnmessstreifen) werden hier Kraft-Messeinrichtungen bezeichnet, welche auf der Änderung des elektrischen Widerstandes durch dehnende oder stauchende Verformungen beruhen.

Das Wegmesselement ist vorzugsweise als induktiver Wegsensor ausgebildet.

Besonders vorteilhaft ist es, wenn in zumindest einem Kontaktelement ein elektrischer Spannungssensor integriert ist. Dadurch kann die elektrische Spannung der Zellpole bei Lade- und Entladevorgängen laufend gemessen werden.

Im Rahmen der Erfindung kann weiters vorgesehen sein, dass zwischen zumindest einer Platte und der Batteriezelle ein Zell-Kompressionspolster angeordnet ist.

Mit der erfindungsgemäßen Vorrichtung ist es möglich, Batteriezellen hinsichtlich ihrer elektrochemischen und physikalischen Eigenschaften (etwa Steifigkeit) zu testen.

Mit der Vorrichtung wird die Batteriezelle zwischen einer ersten Platte und einer zweiten Platte eingespannt und zumindest eine Platte mit einer definierten mechanischen Anpresskraft gegen die Batteriezelle gepresst, wobei eine Reaktionskraft zwischen Batteriezelle und zumindest einer Platte gemessen wird. Die Lösung der Aufgabe erfolgt dadurch, dass - vorzugsweise gleichzeitig mit der Reaktionskraft - auch zumindest eine Änderung der Dicke der Batteriezelle gemessen wird.

In einer erfindungsgemäßen Ausführung ist dabei vorgesehen, dass zumindest zwei Reaktionskräfte an verschiedenen Orten der Batteriezelle gemessen werden.

In weiterer Ausführung der Erfindung ist vorgesehen, dass die Änderung der Dicke an einem anderen Ort der Batteriezelle gemessen wird als die Reaktionskraft.

Dadurch ist es möglich, ein exaktes Zell-Ausdehnungsprofil der Batteriezelle zu erstellen.

Eine weitere Erhöhung der Genauigkeit der Aussagekraft der Untersuchung kann erzielt werden, wenn basierend auf den Messergebnissen eine Modellrechnung mit einem virtuellen Berechnungsmodell der Vorrichtung - vorzugsweise mittels inverser Parameteridentifikation - durchgeführt wird, wobei Stör- und Einflussgrößen der Vorrichtung herausgefiltert werden.

Die Erfindung wird im Folgenden anhand des in den Figuren gezeigten nicht einschränkenden Ausführungsbeispiels näher erläutert. Darin zeigen:
- Fig. 1: eine erfindungsgemäße Vorrichtung in einer axonometrischen Darstellung;
- Fig. 2: die Vorrichtung in einer weiteren axonometrischen Darstellung;
- Fig. 3: die Vorrichtung in einer Explosionsdarstellung;
- Fig. 4: eine Anpressvorrichtung der Vorrichtung in einer geschnittenen axonometrischen Darstellung;
- Fig. 5: die Vorrichtung im Schnitt gemäß der Linie V-V in Fig. 1;
- Fig. 6: die Vorrichtung in einem Schnitt durch die zweite Platte gemäß der Linie VI-VI in Fig. 3;
- Fig. 7: einen Detailschnitt der Vorrichtung aus Fig. 6;
- Fig. 8: ein Kontaktelement der Vorrichtung in einer axonometrischen Darstellung;
- Fig. 9: ein Kraftmesselement der Vorrichtung in einer axonometrischen Darstellung;
- Fig. 10: das Kraftmesselement in einer Seitenansicht;
- Fig. 11: das Detail XI aus Fig. 5; und
- Fig. 12: einen Teststand zur Anwendung der Vorrichtung.

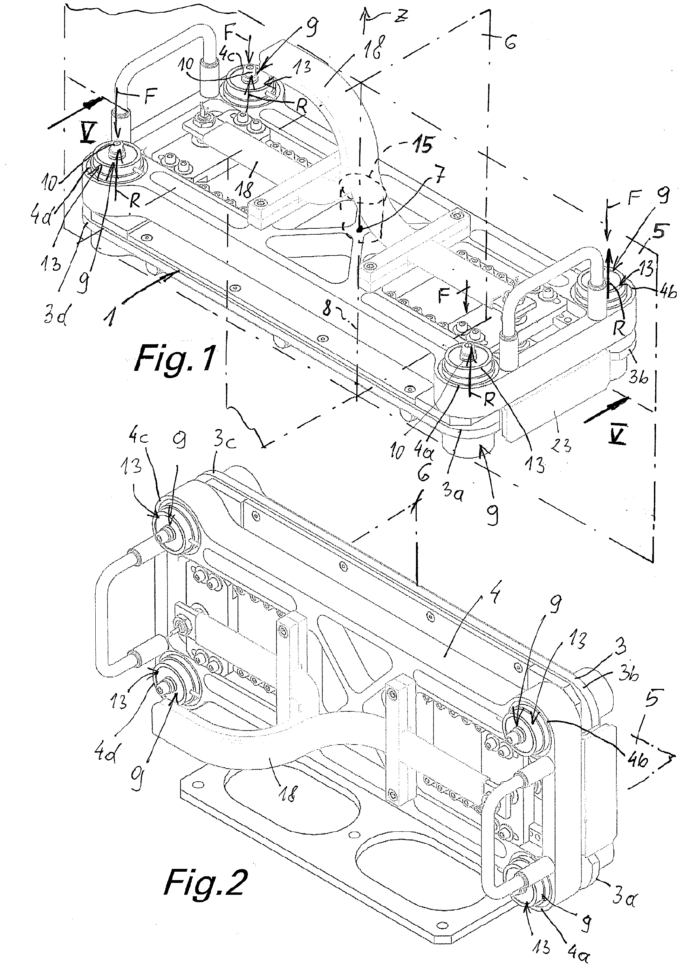

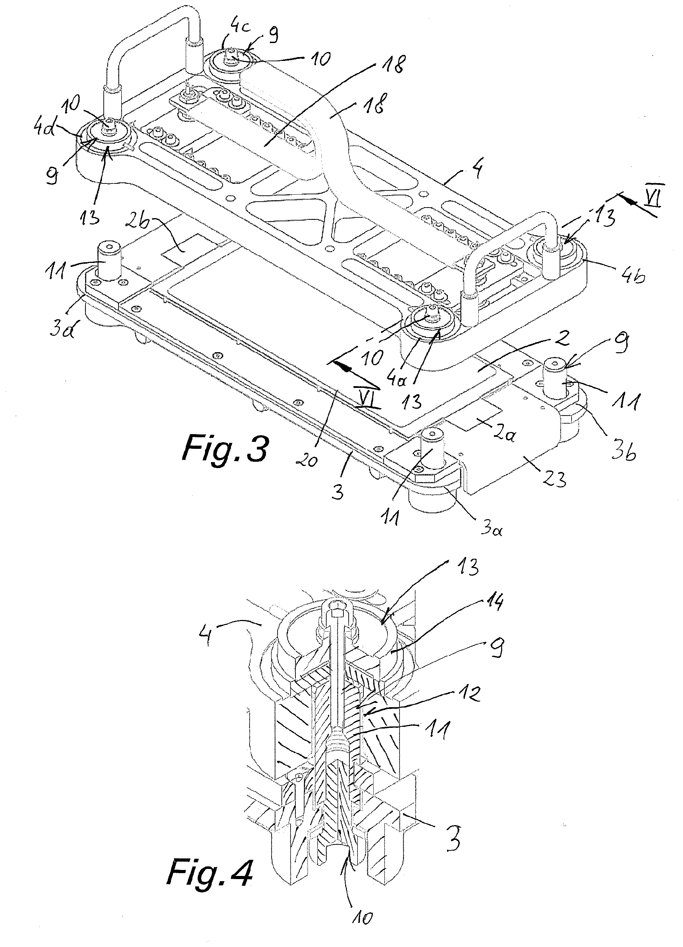

Die in den Fig. 1 bis Fig. 11 gezeigte Vorrichtung 1 zum Testen einer Batteriezelle 2 einer Sekundärbatterie weist eine ersten Platte 3 und eine zweiten Platte 4 auf. Die Batteriezelle 2 kann beispielsweise eine Pouchzelle oder eine prismatische Zelle sein.

Die erste Platte 3 bildet eine untere Basisplattform, in welche die Batteriezelle 2 eingelegt wird. Je nach Zellengröße kann die Basisplattform verschieden groß ausgebildet sein.

Die zweite Platte 4 bildet einen Druckkörper, der mit der unteren Basisplattform über Anpressvorrichtungen 9 verbunden ist. Zwischen dem Druckkörper und der Basisplattform ist die Batteriezelle 2 verspannt.

Die zu testende Batteriezelle 2, welche einen Zellkörper 20 und Zellpole 2a, 2b aufweist, wird also zwischen den beiden im Wesentlichen rechteckigen Platten 3, 4 gehalten und verspannt. Die Platten 3, 4 sind im Ausführungsbeispiel im Wesentlichen symmetrisch bezüglich einer Längsmittelebene 5 und einer dazu normal angeordneten Quermittelebene 6 ausgebildet, wobei die Längsmittelebene 5 und die Quermittelebene 6 durch den Flächenschwerpunkt 7 der Seiten der Platten 3, 4 mit den größten Flächen verlaufen. Mit Bezugszeichen 8 ist die durch den Flächenschwerpunkt 7 verlaufende Verschneidungslinie der Längsmittelebene 5 und der Quermittelebene 6 bezeichnet.

Zumindest eine Platte 3, 4 wird mit zumindest einer definierten mechanischen Anpresskraft F gegen die Batteriezelle 2 gepresst, wobei die beiden Platten 3, 4 durch die Anpressvorrichtungen 9 unter Vorspannung gehalten werden. Die Anpresskräfte F verlaufen parallel zur in Fig. 1 eingezeichneten Hochachse z, also parallel zu der Längsmittelebene 5 und zu der Quermittelebene 6, sowie parallel zur Verschneidungslinien 8 der Längsmittelebene 5 und Quermittelebene 6.

Die Anpressvorrichtungen 9 sind dabei durch symmetrisch bezüglich der Längsebene 5 und der Querebene 6 angeordnete Schraubverbindungen 10 gebildet, wobei bolzen- oder hülsenförmige Abschnitte 11 der Schraubverbindungen 10 durch Öffnungen 12 der Platten 3, 4 geführt sind und diese durchsetzen. Dabei ist an jeder Ecke 3a, 3b, 3c, 3d; 4a, 4b, 4c, 4d der Platten 3, 4 eine Öffnung 12 zur Aufnahme jeweils einer Schraubverbindung 10 angeordnet. Die Ecken 3a, 3b, 3c, 3d; 4a, 4b, 4c, 4d der Platten 3, 4 können abgerundet sein, wie beispielsweise aus den Fig. 1 bis Fig. 3 deutlich hervorgeht.

Die Anpresskraft F wird mittels der Schraubverbindung 10 zwischen Basisplattform - der ersten Platte 3 - und Druckkörper - der zweiten Platte 4 - über beispielsweise als Stehbolzen ausgebildete bolzen- oder hülsenförmige Abschnitte 11 auf den Zellkörper 20 aufgebracht. Dabei ist je Schraubverbindung 10 ein Kraftmesselement 13 vorgesehen, um die Reaktionskraft R zu messen. Die Reaktionskraft R setzt sich aus der als Vorspannung durch die Anpressvorrichtung 9 initial aufgebrachten Anpresskraft F sowie der bei den Testbedingungen durch Temperatur und Ladezustand sowie Lade-/Entladevorgänge resultierenden Betriebskraft der Batteriezelle zusammen. Die Betriebskraft ist im Wesentlichen auf chemische Prozesse im Inneren des Zellkörpers zurückzuführen.

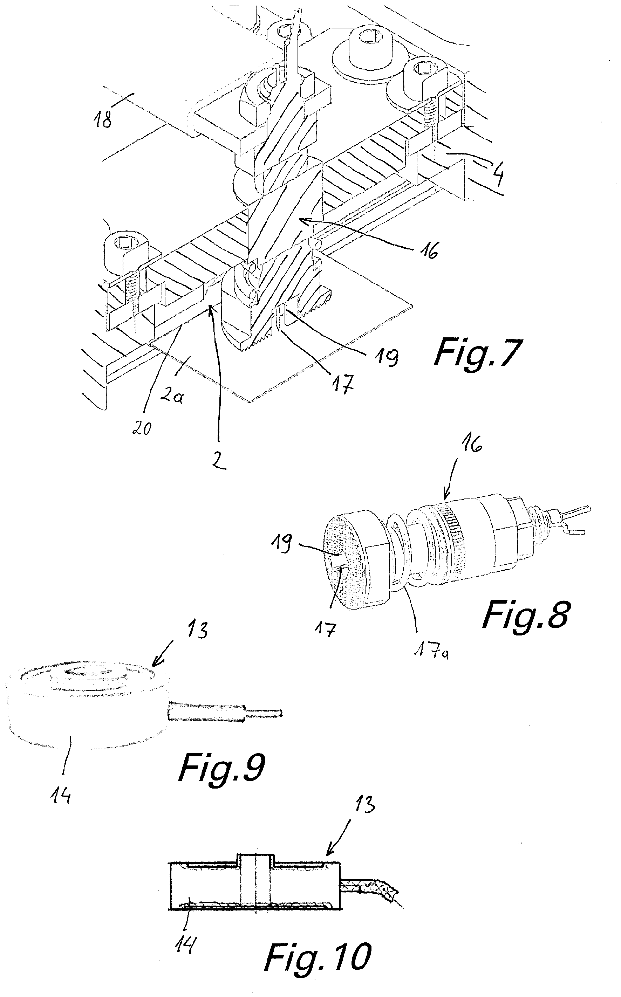

Dieses Kraftmesselement 13 misst die aktuelle Schraubenkraft und somit den Oberflächendruck auf die Batteriezelle 2. Jeweils ein Kraftmesselement 13 ist also zwischen zumindest einer Platte - beispielsweise der zweiten Platte 4 - und jeder Anpressvorrichtung 9 angeordnet. Das Kraftmesselement 13 - etwa ein DMS-Sensor - ist beispielsweise als Kraftmessring 14 ausgebildet, welcher von einem bolzen- oder hülsenförmigen Abschnitt der Anpressvorrichtung 9 durchsetzt ist. Eine genaue Kraftmessung kann erreicht werden, wenn an jeder Ecke 3a, 3b, 3c, 3d; 4a, 4b, 4c, 4d zumindest einer Platte 3, 4, jeweils ein Kraftmesselement 13 zwischen der Platte 3, 4 und einer Anpressvorrichtung 9 angeordnet ist. Die Fig. 9 und Fig. 10 zeigen ein Beispiel für ein Kraftmesselement 13.

Als Erweiterung kann bei jeder Schraubverbindung 10 zwischen erster Platte 3 und zweiter Platte 4 zumindest eine - nicht weiter dargestellte - Feder integriert sein. Diese dient zur Simulation einer "schwimmenden" Lagerung der Batteriezelle 2 im Batterieverbund und erlaubt eine Relativbewegung des Druckkörpers zur Basisplattform, also der zweiten Platte 4 gegenüber der ersten Platte 3.

Alternativ - oder zusätzlich - zu den Federn kann zumindest ein beispielsweise durch eine Elastomermatte gebildeter Zell-Kompressionspolster (Compression Pad) zwischen der Batteriezelle 2 und der zweiten Platte 4 platziert werden (in den Fig. nicht dargestellt).

Sowohl die Federn als auch der Zell-Kompressionspolster können in ihrer Steifigkeit passend zum Anwendungsfall definiert werden und bilden somit einen realen Abgleich der Einbausituation im Batterie Pack ab.

Die Steifigkeit der Vorrichtung 1 kann variabel mittels Federn unterschiedlicher Steifigkeit angepasst werden, so dass konstante Kräfte über den gesamten Ausdehnungsbereich von 300N bis zu 10kN realisiert werden können.

Darüber hinaus ist es möglich, beispielsweise durch Profile gebildete Versteifungselemente an den Seitenkanten der ersten Platte 3 und/oder zweiten Platte 4 anzuschrauben, die eine weitere variable Versteifung ermöglichen. Beispielsweise kann die Steifigkeit des durch die zweite Platte 4 gebildeten Druckkörpers durch Anbringen von nicht weiter dargestellten seitlichen Profilen unterschiedlicher Höhe in diskreten Schritten erhöht werden. In der steifsten Variante sind somit beispielsweise bis zu 40kN Reaktionskraft möglich.

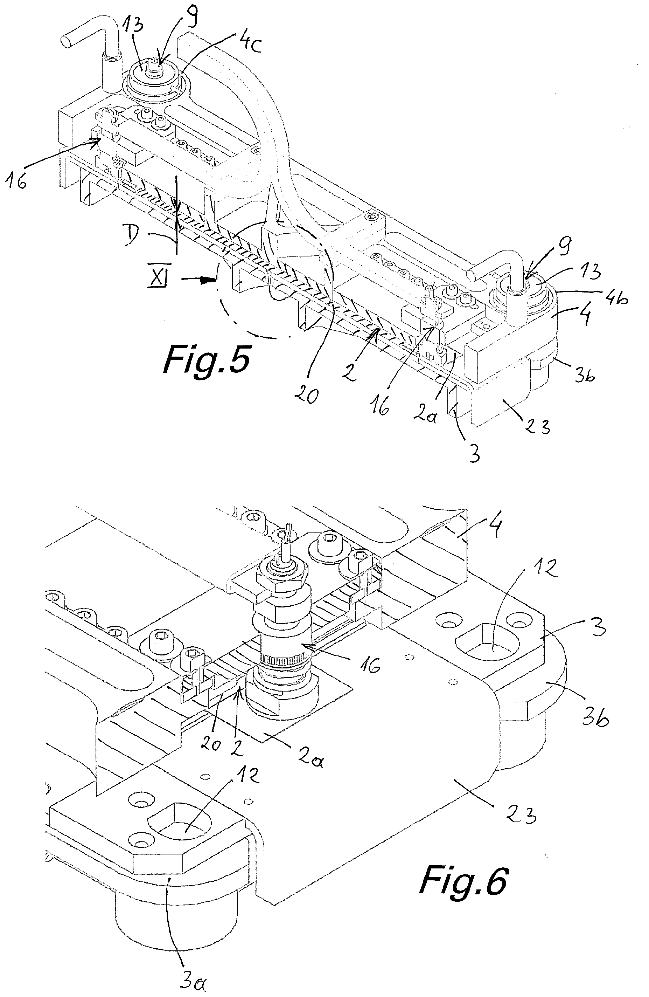

Weiters weist die Vorrichtung 1 zumindest ein Wegmesselement 15 auf, mit welcher die Änderung der Dicke D (Fig. 5) der Batteriezelle 2 gemessen werden kann (Fig. 1). Die Dickenänderung wird in Richtung der in Fig. 1 eingezeichneten Hochachse z gemessen, also im Ausführungsbeispiel in Richtung der geringsten Ausdehnung des Zellkörpers 20. Das Wegmesselement 15 kann beispielsweise als induktiver Wegsensor ausgebildet sein, welcher im Bereich der Verschneidungslinie 8 zwischen der Längsmittelebene 5 und der Quermittelebene 6 angeordnet ist.

Das Wegmesselement 15 ist durch einen separaten Bauteil und örtlich getrennt zu den Kraftmesselementen 13 ausgebildet. Das Wegmesselement 15 kann direkt an der Vorrichtung 1 befestigt werden. Das Wegmesselement 15 dient dazu die Volumenänderung (Breathing) des Zellkörpers 20 beim Laden bzw. Entladen unterschiedlicher Ladezustände und bei unterschiedlichen Temperaturen zu messen. Das Wegmesselement 15 dient dazu, das Breathing der Batteriezelle 2 bei unterschiedlichen Temperaturen beim Laden bzw. Entladen zu messen. Auch die Ausdehnung (Swelling) des Zellkörpers 20 aufgrund von Alterung der Batteriezelle 2 kann mit dem Wegmesselement 15 gemessen werden.

Durch die unterschiedlichen Positionen der Kraftmesselemente 13 und des Wegmesselementes 15 können gleichzeitig Kraft- und Wegmessungen durchgeführt und somit ein exaktes Zell-Ausdehnungsprofil der untersuchten Batteriezelle 2 erstellt werden.

Im Bereich der Zellpole 2a, 2b der Batteriezelle 2 sind in der zweiten Platte 4 Kontaktelemente 16 mit jeweils durch eine Druckfeder 17a vorgespannte elektrische Kontaktbolzen 17 angeordnet, welche einen elektrischen Kontakt zwischen den Zellpolen 2a, 2b und einem flexiblen Stromkabel 18 herstellen. In zumindest eines der Kontaktelemente 16 ist ein Temperatursensor 19 integriert. Für eine genaue Temperaturüberwachung ist es besonders günstig, wenn pro elektrischem Kontaktelement 16 ein Temperatursensor 19 vorgesehen ist. Über das Kontaktelement 16 kann auch die elektrische Spannung gemessen werden, beispielsweise um eine Kompensation von Leitungsverlusten zu ermöglichen.

Durch die feste Integration der Kontaktelemente 16 in der zweiten Platte 4 ist ein schnelles Wechseln und erneutes rasches Kontaktieren möglich.

Zur Wärmeableitung und Zellpolkühlung kann eventuell eine Wärmeableitplatte 23 vorgesehen sein (Fig. 6).

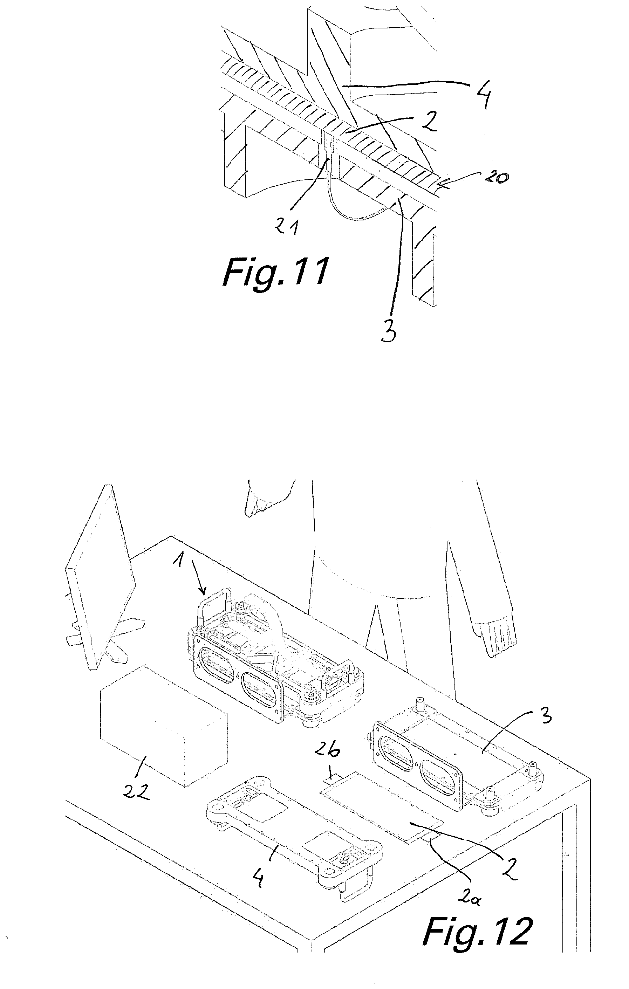

Weiters ist in der ersten Platte 3 ein federbelastetes thermisches Messelement 21 angeordnet, welches in einem mittigen Bereich von unten gegen die Batteriezelle 2 gedrückt wird, wie in Fig. 11 gezeigt ist. Über das thermisches Messelement 21 kann die Zellkörpertemperatur der Batteriezelle 2 gemessen werden.

Alle Messungen (Strom, Spannung, Druckkräfte, Relativbewegung) können im Betrieb aufgezeichnet und direkt verglichen werden. Die Steifigkeit der Federn oder der Zell-Kompressionspolster ist je nach Bedarf zu wählen.

Die Vorrichtung 1 ist für Testumgebungen in Temperaturkammern mit Temperaturen beispielsweise zwischen etwa -30°C - +70°C geeignet.

Die kompakte Baugröße der Vorrichtung 1 erlaubt bzw. erleichtert das Testen mehrerer Prüflinge in Temperaturkammern. Für belastbare Ergebnisse sind erfahrungsmäßig mindestens zwölf unterschiedliche Testkonfigurationen mit mindestens je drei Wiederholungen notwendig. Es können somit sowohl monitäre als auch ökonomische Vorteile erzielt werden.

Stehen geringe Testressourcen (Temperaturkammern/Klimakammern) zur Verfügung und muss beispielsweise jede Batteriezelle 2 nacheinander getestet werden, bietet die kompakte Bauart einen wesentlichen Zeitvorteil zum Erlangen der gewünschten Testergebnisse.

Durch das gleichzeitige Messen von Kraft und Ausdehnung ist es möglich, die Steifigkeit der Testumgebung sowie die Steifigkeit der Batteriezelle 2 zu jedem Zeitpunkt während der Zyklisierung/Alterung zu bestimmen. Da sich die Zellsteifigkeit im Verlauf des elektrischen Zyklisierens verändert, ist dies ein wesentlicher Parameter in der mechanischen Auslegung des Verbunds mehrerer Batteriezellen 2 zu einem Modul. Dieser Aspekt wurde bei konventionellen bekannten Vorrichtungen bisher nicht berücksichtigt und führte zu unzureichenden Daten.

Die Baugröße der vorliegenden Vorrichtung 1 ist besonders kompakt, so dass es möglich ist mehrere Vorrichtungen 1 innerhalb einer marktüblichen Zelltestkammer unterzubringen. Damit kann auch der Einfluss unterschiedlicher Umgebungstemperaturen miterfasst werden. Zusätzlich wird es dadurch erst möglich, viele Batteriezellen parallel testen zu können, was nötig ist, um eine ausreichende Charakterisierung des Zell-Swelling und/oder Zell-Breathing Verhaltens vorzunehmen.

Die Vorrichtung 1 wird günstigerweise durch ein virtuelles Berechnungsmodell ergänzt, mit dem begleitend oder ergänzend zu den Hardware-Tests eine Modellrechnung durchgeführt werden kann. Mit dem virtuellen Berechnungsmodell der Vorrichtung 1 ist es möglich, die reinen Zelleigenschaften der Batteriezelle 2 zu erhalten und alle Stör-Einflüsse der Messapparatur herauszufiltern. Dadurch wird vermieden, dass die durch die Vorrichtung 1 generierten Daten durch die Vorrichtung 1 und den Messaufbau selbst verfälscht werden. Dies ermöglicht - im Vergleich zu konventionellen Verfahren - eine höhere Genauigkeit und bessere Aussagekraft.

Mit der Vorrichtung 1 können folgende Untersuchungen durchgeführt werden:
1. Simulation des Oberflächendrucks auf dem Zellkörper der Batteriezelle 2, beispielsweise bis 40kN oder darüber. Dadurch kann untersucht werden, bei welchem Vorspanndruck die Batteriezelle die höchste Performanz erreicht. Dazu wird eine Echtzeit Oberflächendruckmessung mittels der vier Kraftmesselementen 13 durchgeführt. Weiters werden reproduzierbare Oberflächendrücke durch die Kraftmesselemente 13 bei jedem Test und jeder Batteriezelle 2 ermittelt. Schließlich wird auch noch eine Temperaturmessung am Zellenkörper 20 der Batteriezelle 2 einerseits und an den Kontaktelementen16 andererseits durchgeführt.
2. Simulation unterschiedlicher Steifigkeiten zum Ausgleich der Zellenausdehnung (Breathing, Swelling) der Batteriezelle 2. Dadurch kann untersucht werden, wie der Batterieverbund hinsichtlich der Ausdehnung der Batteriezellen konstruiert werden muss. Dies kann beispielsweise durch Integration von Zell-Kompressionspolstern und/oder Federn zwischen Platte 3, 4 und Batteriezelle 2 erfolgen.
3. Ermittlung der Batteriezellenausdehnung bei unterschiedlichen Batterieladezuständen und Temperaturen. Dadurch kann untersucht werden, wie sich die Geometrie (Dicke) der Batteriezelle 2 bei unterschiedlichen Ladezuständen und unterschiedlichen Temperaturen ändert. Dies erfolgt durch zusätzliche Wegmessung mittels zumindest eines Wegmesselementes 15.

Die vorliegende Vorrichtung 1 wurde speziell entwickelt um Zell-Breathing und/ oder Zell-Swelling (Zell-Dickenwachstum aufgrund elektro-chemischer Umwandlungsprozesse während der elektrischen Zyklisierung) von Batteriezellen 2 (Pouchzellen und prismatische Zellentypen) vollumfänglich zu charakterisieren. Mit den dadurch generierten Daten ist es dann möglich, eine detaillierte mechanische Auslegung eines Zellverbunds (z.B. eines Batteriemoduls) durchzuführen.

Zu diesem Zwecke ist das virtuelle Berechnungsmodell der Vorrichtung 1 vorgesehen. Durch die Kombination der Vorrichtung 1 mit dem virtuellen Berechnungsmodell können schließlich mit Hilfe inverser Parameteridentifikation die wahren Zelleigenschaften (bereinigt um den Einfluss der Messapparatur) ermittelt werden, sowie ein Simulationsmodell zum Breathing-Verhalten und/oder Swelling-Verhalten der jeweils getesteten Batteriezelle 2 erstellt werden.

Um das Breathing-Verhalten und/oder Swelling-Verhalten einer Batteriezelle 2 vollumfänglich zu charakterisieren müssen folgende Abhängigkeiten getestet werden:
- ) Änderung der Dicke D der Batteriezelle 2 über elektrische Zyklenzahl (in Abhängigkeit von Umgebungssteifigkeit): Die Änderung der Dicke D der Batteriezelle 2 wird durch ein Wegmesselement 15 in der Mitte des Zellkörpers 20 gemessen. Dieses Wegmesselement 15 misst grundsätzlich die Relativverschiebung zwischen den beiden Platten 3, 4. Der gemessene Verschiebungswert (zusammen mit dem gemessenen Kraftwert) wird dann mit Hilfe des virtuelle Berechnungsmodells weiterverarbeitet, um so die reine Änderung der Dicke D der Batteriezelle 2, sowie die zugehörige Zellsteifigkeit, das Ausdehnungsprofil und die Druckabhängigkeit, zu erhalten.
- ) Kraftanstieg durch Änderung der Dicke D der Batteriezelle 2 über elektrische Zyklenzahl (in Abhängigkeit von Umgebungssteifigkeit): Um den Kraftanstieg durch die Dickenänderung der Batteriezelle 2 zu messen, sind vier durch Kraftmessringe 14 gebildete Kraftmesselemente 15 an den äußeren Ecken 3a, 3b, 3c, 3d; 4a, 4b, 4c, 4d der Platten 3, 4 verbaut. Durch die Positionierung der Kraftmesselemente 15 ist es nicht nur möglich den mittleren Kraftanstieg zu messen, sondern auch lokale Unterschiede. Der gemessene Kraftwert (zusammen mit dem gemessenen Verschiebungswert) wird dann mit Hilfe des virtuelle Berechnungsmodells weiterverarbeitet, um so die reine Änderung der Dicke D der Batteriezelle 2 und die zugehörige Zellsteifigkeit, das Ausdehnungsprofil und die Druckabhängigkeit zu erhalten.
- ) Steifigkeitsänderung der Batteriezelle 2 über elektrische Zyklenzahl: Wenn der Kraftanstieg und die Änderung der Dicke D nur während der Zyklisierung gemessen werden, erhält man keine Information über die Zellsteifigkeit, sondern nur eine Aussage über die Steifigkeit der Vorrichtung 1. Das bedeutet, dass es viele Paare an Zellsteifigkeit und reiner Änderung der Dicke D der Batteriezelle 2 gibt, die in Kombination das gleiche Messergebnis liefern. Aus diesem Grund muss zu festgelegten Zyklenzahlen die elektrische Zyklisierung unterbrochen werden und die Zellsteifigkeit gemessen werden. Dabei ist es wichtig, dass die Batteriezelle 2 beispielsweise nicht ausgebaut und in eine andere Messvorrichtung eingebaut werden muss, da dadurch das Ergebnis verfälscht werden könnte. Die vorliegende Vorrichtung 1 ist genau zu diesem Zweck ausgelegt und bietet deswegen die Möglichkeit der gleichzeitigen Kraft und Wegmessung. Darüber hinaus kann durch die Positionierung der Kraftmesselemente 15 an den Schraubverbindungen 10 zu jedem Zeitpunkt durch synchrones Lösen oder /Anziehen aller Schraubverbindungen 10 kraftgesteuert die Zellsteifigkeit gemessen werden. Mit anderen Worten, es erfolgt ein mehrstufiges Lösen oder Anziehen der Schraubverbindungen 10 bei gestoppter elektrischer Zyklisierung, ohne dass die Batteriezelle 2 ausgebaut werden muss. Dadurch erhält man Kraft/Weg Kurven, die dann mittels des virtuellen Berechnungsmodells nochmal verfeinert werden, um die reine Zellsteifigkeit zu extrahieren. Dabei wird der Einfluss der Apparatursteifigkeit herausgefiltert. Wenn nun die Zellsteifigkeit bezogen auf die Zyklenzahl bekannt ist, gibt es nur einen Wert an Zelldickenwachstum, mit dem der gemessene Kraftanstieg erreicht werden kann. Nur durch diese Kombination ist es möglich, die tatsächlichen Zelleigenschaften aus dem Test zu ermitteln.
- ) Ausdehnungsprofil der Batteriezelle 2: Die Änderung der Dicke D der Batteriezelle 2 erfolgt nicht gleichmäßig über die gesamte Oberfläche. Stattdessen stellt man in der Regel eine größere Änderung der Dicke D in der Zellmitte verglichen mit der Zellberandung fest. Dieser Einfluss ist maßgeblich für die Integration einer Batteriezelle 2 in einen Zellverbund. Um diesen Effekt zu messen, sind in der vorliegenden Vorrichtung 1 die Kraftmesselemente 13 an den vier Ecken 3a, 3b, 3c, 3d; 4a, 4b, 4c, 4d der Platten 3, 4 am Rand der Batteriezelle 2 angebracht und das Wegmesselement 15 zur Messung der Zellausdehnung in der Mitte der Batteriezelle 2. Wenn es nun zu einem hohen Kraftanstieg aber geringer Wegänderung kommt, ist das Dickenwachstum am Rand der Batteriezelle 2 ausgeprägt. Kommt es zu einer großen Wegänderung und nur einer kleinen Kraftänderung, ist das Dickenwachstum in der Mitte der Batteriezelle 2 ausgeprägt. Auf diese Weise kann nicht nur das mittlere Zell-Dickenwachstum charakterisiert werden, sondern auch das Ausdehnungsprofil. Neben der entsprechenden Positionierung der Kraftmesselemente 13 und des Wegmesselementes 15 ist dafür die gleichzeitige Messung von Kraft und Weg notwendig.
- ) Druckabhängigkeit der Änderung der Dicke D der Batteriezelle 2 über elektrische Zyklenzahl: Die Ausdehnung der Batteriezelle 2 ist im Regelfall abhängig davon, welcher mechanische Druck während der elektrischen Zyklisierung auf die Zelloberfläche wirkt. Um diesen Effekt zu charakterisieren, ist die vorliegende Vorrichtung 1 sehr flexibel hinsichtlich der einstellbaren Vorspannungen und auch Steifigkeiten konstruiert. Der Vorspannungsbereich reicht beispielsweise von ca. 100N bis zu etwa 40kN.

Um die Druckabhängigkeit vollständig zu charakterisieren, reicht es nicht aus nur die initiale Verspannung zu kontrollieren. Darüber hinaus muss auch der durch das Dickenwachstum der Batteriezelle 2 bedingte Kraft-/Druckverlauf während der Zyklisierung kontrolliert werden. Dazu ist in der vorliegenden Vorrichtung 1 die Möglichkeit vorgesehen, die Steifigkeit der Zelleinspannung mittels Federn mit unterschiedlichen Steifigkeiten variabel gestalten zu können. So ist es möglich, eine konstante Verspannungssituation über die gesamte elektrische Zyklisierung zu erreichen. Durch den Einsatz von Federn mit unterschiedlicher Federsteifigkeit können unterschiedliche Druck-Niveaus konstant gehalten werden. Auf diese Weise erhält man das Zelldickenwachstum für die jeweiligen Druckniveaus. Um darüber hinaus noch den Einfluss eines veränderlichen Drucks während der Zyklisierung zu charakterisieren, kann die Batteriezelle 2 in der Vorrichtung 1 auch starr mittels der Schraubverbindung 10 verspannt werden. In diesem Fall ist der Kraft/Druckanstieg abhängig von der Steifigkeit der Platten 3, 4. Auch hier ist die Möglichkeit vorgesehen, die Steifigkeiten der Platten 3, 4 durch die zusätzliche Montage von Seitenprofilen in zwei Schritten zu variieren. Dadurch erhält man genügend Variationsmöglichkeit, um alle in einem Zellverbund möglichen Verspannungssituationen mit der Vorrichtung 1 abzubilden.

Fig. 12 zeigt einen Teststand mit zwei Vorrichtungen 1 zum Testen von mehreren Batteriezellen 2, welche sich in verschiedenen Applikationszuständen befinden. Die rechte und im Vordergrund darrgestellte Vorrichtung 1 ist dabei noch nicht zusammengebaut und die linke Vorrichtung 1 bereits vollständig montiert.

Die Vorbereitung der Vorrichtung 1 erfolgt in folgenden Schritten:
- Einsetzen der Batteriezelle 2 in die durch die erste Platte 3 gebildete Basisplattform;
- Eventuelles Aufsetzen eines Zell-Kompressionspolsters auf die Batteriezelle 2;
- Aufsetzen der zweiten Platte 4 auf die Batteriezelle 2 bzw. auf den Zell-Kompressionspolster;
- Anbringen der Schraubverbindung 10 mit den Kraftmesselementen 13;
- Verbinden der Kraftmesselemente 13 mit einer Messeinheit 22;
- kreuzweises Anziehen der Schraubverbindungen 10 in mehreren Schritten, wobei die Zellpole 2a, 2b durch die Kontaktelemente 16 automatisch kontaktiert werden;
- Überwachen der symmetrischen Kraftzunahme an jeder Schraubverbindung 10.

## Patentansprüche

1. Vorrichtung (1) zum Testen zumindest einer Batteriezelle(2), insbesondere einer Sekundärbatterie, mit einer ersten Platte (3) und einer zweiten Platte (4), wobei die Batteriezelle (2) zwischen den beiden - vorzugsweise im Wesentlichen rechteckigen - Platten (3, 4) eingespannt ist und zumindest eine Platte (4) mit einer definierten mechanischen Anpresskraft (F) gegen die Batteriezelle (2) gepresst ist, mit zumindest einem zwischen einer Platte (3, 4) und zumindest einer Anpressvorrichtung (9) angeordneten Kraftmesselement (13) zur Messung einer Reaktionskraft (R) zwischen der Batteriezelle (2) und der Anpressvorrichtung (9), wobei mittels zumindest eines Wegmesselements (15) - vorzugsweise gleichzeitig mit der Reaktionskraft (R) - zumindest eine Änderung einer Dicke (D) der Batteriezelle (2) messbar ist, **dadurch gekennzeichnet, dass** zumindest eine Platte (3, 4), vorzugsweise die erste Platte (3), zumindest ein thermisches Messelement (21) zur Messung der Zellkörpertemperatur der Batteriezelle (2) aufweist, und dass zumindest eine Platte (3, 4), vorzugsweise die zweite Platte (4), zumindest ein Kontaktelement (16) aufweist, welches eine elektrische Verbindung zwischen zumindest einem Zellpol (2a, 2b) und einem vorzugsweise flexiblen Stromkabel (18) herstellt, wobei in zumindest ein Kontaktelement (16) ein Temperatursensor (19) integriert ist.

2. Vorrichtung (1) nach Anspruch 1, **dadurch gekennzeichnet, dass** zumindest ein Kraftmesselement (13) und zumindest ein Wegmesselement (15) durch separate und/oder örtlich getrennte Bauteile gebildet sind.

3. Vorrichtung (1) nach Anspruch 1 oder 2, **dadurch gekennzeichnet, dass** zumindest ein Wegmesselement (15) im Bereich einer Längsmittelebene (5) und/oder einer Quermittelebene (6) der Batteriezelle (2) und/oder zumindest einer Platte (3, 4) angeordnet ist.

4. Vorrichtung (1) nach einem der Ansprüche 1 bis 3, **dadurch gekennzeichnet, dass** das Wegmesselement (15) im Bereich einer Verschneidungslinie (8) zwischen einer Längsmittelebene (5) und einer Quermittelebene (6) der Batteriezelle (2) und/oder zumindest einer Platte (3, 4) angeordnet ist.

5. Vorrichtung (1) nach einem der Ansprüche 1 bis 4, **dadurch gekennzeichnet, dass** die erste Platte (3) und die zweite Platte (4) durch die zumindest eine Anpressvorrichtung (9) miteinander verbunden sind, wobei vorzugsweise die Anpressvorrichtung (9) im Bereich einer Ecke (3a, 3b, 3c, 3d; 4a, 4b, 4c, 4d) der ersten Platte (3) und der zweiten Platte (4) angeordnet ist.

6. Vorrichtung (1) nach einem der Ansprüche 1 bis 5, **dadurch gekennzeichnet, dass** im Bereich zumindest zweier Ecken (3a, 3b, 3c, 3d; 4a, 4b, 4c, 4d) zumindest einer Platte (3; 4) - vorzugsweise an jeder Ecke (3a, 3b, 3c, 3d; 4a, 4b, 4c, 4d) zumindest einer Platte (3; 4) - jeweils ein Kraftmesselement (13) zwischen der Platte (3, 4) und einer Anpressvorrichtung (9) angeordnet ist.

7. Vorrichtung (1) nach einem der Ansprüche 1 bis 6, **dadurch gekennzeichnet, dass** zumindest eine Kraftmesselement (13) als Kraftmessring (14) ausgebildet ist, wobei vorzugsweise der Kraftmessring (14) von einem bolzen- oder hülsenförmigen Abschnitt (11) der Anpressvorrichtung (9) durchsetzt ist.

8. Vorrichtung (1) nach einem der Ansprüche 1 bis 7, **dadurch gekennzeichnet, dass** zumindest ein Kraftmesselement (13) als DMS-Sensor ausgebildet ist.

9. Vorrichtung (1) nach einem der Ansprüche 1 bis 8, **dadurch gekennzeichnet, dass** das Wegmesselement (15) als induktiver Wegsensor ausgebildet ist.

10. Vorrichtung (1) nach einem der Ansprüche 1 bis 9, **dadurch gekennzeichnet, dass** in zumindest ein Kontaktelement (16) ein Spannungssensor integriert ist.

11. Vorrichtung (1) nach einem der Ansprüche 1 bis 10, **dadurch gekennzeichnet, dass** zwischen zumindest einer Platte (3, 4) und der Batteriezelle (2) zumindest ein Zell-Kompressionspolster und/oder zumindest eine Feder mit definierter Steifigkeit angeordnet ist.

12. Verfahren zum Testen zumindest einer Batteriezelle (2), insbesondere einer Sekundärbatterie, mit einer Vorrichtung (1) nach einem der Ansprüche 1 bis 11, wobei die Batteriezelle (2) zwischen einer ersten Platte (3) und einer zweiten Platte (4) eingespannt wird und zumindest eine Platte (4) mit einer definierten mechanischen Anpresskraft (F) gegen die Batteriezelle (2) gepresst wird, wobei zumindest eine Reaktionskraft (R) zwischen Batteriezelle (2) und zumindest einer Platte (4) gemessen wird, **dadurch gekennzeichnet, dass** - vorzugsweise gleichzeitig mit der Reaktionskraft (R) - auch zumindest eine Änderung der Dicke (D) der Batteriezelle (2) gemessen wird.

13. Verfahren nach Anspruch 12, **dadurch gekennzeichnet, dass** zumindest eine Reaktionskraft (R) und zumindest eine Änderung der Dicke (D) der Batteriezelle (2) an verschiedenen Orten der Batteriezelle (2) gemessen werden.

14. Verfahren nach Anspruch 12 oder 13, **dadurch gekennzeichnet, dass** zumindest zwei Reaktionskräfte (R) an verschiedenen Orten der Batteriezelle (2) gemessen werden.

15. Verfahren nach einem der Ansprüche 12 bis 14, **dadurch gekennzeichnet, dass** basierend auf den Messergebnissen eine Modellrechnung mit einem virtuellen Berechnungsmodell der Vorrichtung (1) und/oder der Batteriezelle (2) - vorzugsweise mittels inverser Parameteridentifikation - durchgeführt wird, wobei Stör- und Einflussgrößen der Vorrichtung (1) herausgefiltert werden.

## Claims

1. Device (1) for testing at least one battery cell (2), in particular a secondary battery, having a first plate (3) and a second plate (4), wherein the battery cell (2) is clamped between the two plates (3, 4), which are preferably substantially rectangular, and at least one plate (4) is pressed against the battery cell (2) with a defined mechanical pressing force (F), having at least one force-measuring element (13) arranged between one plate (3, 4) and at least one pressing device (9) for measuring a reaction force (R) between the battery cell (2) and the pressing device (9), wherein at least one change in a thickness (D) of the battery cell (2) can be measured, preferably simultaneously with the reaction force (R), by means of at least one displacement-measuring element (15), **characterised in that** at least one plate (3, 4), preferably the first plate (3), has at least one thermal measuring element (21) for measuring the cell body temperature of the battery cell (2) and that at least one plate (3, 4), preferably the second plate (4), has at least one contact element (16) which establishes an electrical connection between at least one cell pole (2a, 2b) and a preferably flexible power cable (18), wherein a temperature sensor (19) is integrated in at least one contact element (16)

2. Device (1) according to claim 1, **characterised in that** at least one force-measuring element (13) and at least one displacement-measuring element (15) are formed by separate and/or locally separated components.

3. Device (1) according to claim 1 or 2, **characterised in that** at least one displacement-measuring element (15) is arranged in the region of a longitudinal center plane (5) and/or a transverse center plane (6) of the battery cell (2) and/or at least one plate (3, 4).

4. Device (1) according to one of claims 1 to 3, **characterised in that** the displacement-measuring element (15) is arranged in the region of an intersection line (8) between a longitudinal center plane (5) and a transverse center plane (6) of the battery cell (2) and/or at least one plate (3, 4).

5. Device (1) according to one of claims 1 to 4, **characterised in that** the first plate (3) and the second plate (4) are connected to one another by the at least one pressing device (9), wherein the pressing device (9) is preferably arranged in the region of a corner (3a, 3b, 3c, 3d; 4a, 4b, 4c, 4d) of the first plate (3) and the second plate (4).

6. Device (1) according to one of claims 1 to 5, **characterised in that** in the region of at least two corners (3a, 3b, 3c, 3d; 4a, 4b, 4c, 4d) of at least one plate (3; 4), preferably at each corner (3a, 3b, 3c, 3d; 4a, 4b, 4c, 4d) of at least one plate (3; 4), a force-measuring element (13) is arranged in each case between the plate (3, 4) and a pressing device (9).

7. Device (1) according to one of claims 1 to 6, **characterised in that** at least one force-measuring element (13) is designed as a force measuring ring (14), wherein preferably the force measuring ring (14) is penetrated by a bolt- or sleeve-shaped section (11) of the pressing device (9).

8. Device (1) according to one of claims 1 to 7, **characterised in that** at least one force-measuring element (13) is designed as a strain gauge sensor.

9. Device (1) according to one of claims 1 to 8, **characterised in that** the displacement-measuring element (15) is designed as an inductive displacement sensor.

10. Device (1) according to one of claims 1 to 9, **characterised in that** a voltage sensor is integrated in at least one contact element (16).

11. Device (1) according to one of claims 1 to 10, **characterised in that** at least one cell compression pad and/or at least one spring with defined stiffness is arranged between at least one plate (3, 4) and the battery cell (2).

12. Method for testing at least one battery cell (2), in particular a secondary battery, having a device (1) according to one of claims 1 to 11, wherein the battery cell (2) is clamped between a first plate (3) and a second plate (4) and at least one plate (4) is pressed against the battery cell (2) with a defined mechanical pressing force (F), wherein at least one reaction force (R) between battery cell (2) and at least one plate (4) is measured, **characterised in that** at least one change in the thickness (D) of the battery cell (2) is also measured, preferably simultaneously with the reaction force (R).

13. Method according to claim 12, **characterised in that** at least one reaction force (R) and at least one change in thickness (D) of the battery cell (2) are measured at different locations of the battery cell (2).

14. Method according to claim 12 or 13, **characterised in that** at least two reaction forces (R) are measured at different locations of the battery cell (2).

15. Method according to one of claims 12 to 15, **characterised in that**, based on the measurement results, a model calculation is carried out with a virtual calculation model of the device (1) and/or the battery cell (2), preferably by means of inverse parameter identification, wherein disturbance variables and influencing variables of the device (1) are filtered out.

## Revendications

1. Dispositif (1) pour tester au moins une cellule de batterie (2) notamment d'une batterie secondaire comprenant une première plaque (3) et une seconde plaque (4),
- la cellule de batterie (2) étant serrée entre les deux plaques (3, 4) -de préférence pratiquement rectangulaires- et au moins une plaque (4) est pressée avec une force d'application (F) défini mécaniquement contre la cellule de batterie (2), avec au moins un élément de mesure de force (13) installé entre une plaque (3, 4) et au moins un dispositif de pression (9), pour mesurer la force de réaction (R) entre la cellule de batterie (2) et le dispositif de pression (9),
- avec au moins un élément de mesure de course (15) -de préférence simultané avec la force de réaction (R)- mesurant au moins une variation d'épaisseur (D) la cellule de batterie (2),
dispositif **caractérisé en ce que**
- au moins une plaque (3, 4), de préférence la première plaque (3), a au moins un élément de mesure thermique (21) pour mesurer la température du corps de cellule de batterie (2), et
- au moins une plaque (3, 4) de préférence la seconde plaque (4) a au moins un élément de contact (16) qui réalise une liaison électrique entre au moins un pôle de cellule (2a, 2b) et de préférence un câble électrique souple (18),
- au moins un capteur de température (19) étant intégré dans l'élément de contact (16).

2. Dispositif (1) selon la revendication 1,
**caractérisé en ce qu'**
au moins un élément de mesure de force (13) et au moins un élément de mesure de course (15) sont réalisés par des composants séparés et/ou séparés localement.

3. Dispositif (1) selon la revendication 1 ou 2,
**caractérisé en ce qu'**
au moins un élément de mesure de course (15) est installé dans la zone du plan médian longitudinal (5) et/ou d'un plan médian transversal (6) de la cellule de batterie (2) et/ou d'au moins une plaque (3, 4).

4. Dispositif (1) selon l'une des revendications 1 à 3,
**caractérisé en ce que**
l'élément de mesure de course (15) est installé dans la zone d'une ligne d'intersection (8) entre un plan médian longitudinal (5) et un plan médian transversal (6) de la cellule de batterie (2) et/ou d'au moins une plaque (3, 4).

5. Dispositif (1) selon l'une des revendications 1 à 4,
**caractérisé en ce que**
la première plaque (3) et la seconde plaque (4) sont reliées l'une à l'autre par au moins un dispositif de pression (9),
* de préférence le dispositif de pression (9) étant installé dans la zone d'un coin (3a, 3b, 3c, 3d ; 4a, 4b, 4c, 4d) de la première plaque (3) et de la seconde plaque (4).

6. Dispositif (1) selon l'une des revendications 1 à 5,
**caractérisé en ce que**
dans la zone d'au moins deux coins (3a, 3b, 3c, 3d ; 4a, 4b, 4c, 4d) d'au moins une plaque (3, 4) -de préférence à chaque coin (3a, 3b, 3c, 3d ; 4a, 4b, 4c, 4d) d'au moins une plaque (3, 4)- il est prévu au moins un élément de mesure de force (13) entre la plaque (3, 4) et le dispositif de pression (9).

7. Dispositif (1) selon l'une des revendications 1 à 6,
**caractérisé en ce qu'**
au moins un élément de mesure de force (13) est réalisé comme anneau de mesure de force (14),
* de préférence l'anneau de mesure de force (14) est traversé par un goujon ou un segment en forme de manchon (11) du dispositif de pression (9).

8. Dispositif (1) selon l'une des revendications 1 à 7,
**caractérisé en ce qu'**
au moins un élément de mesure de force (13) est un capteur DMS (capteur de distance).

9. Dispositif (1) selon l'une des revendications 1 à 8,
**caractérisé en ce que**
l'élément de mesure de course (15) est un capteur inductif de course.

10. Dispositif (1) selon l'une des revendications 1 à 9,
**caractérisé en ce qu'**
un capteur de tension est intégré dans au moins un élément de contact (16).

11. Dispositif (1) selon l'une des revendications 1 à 3,
**caractérisé en ce qu'**
un rembourrage de compression de cellule et/ou au moins un ressort avec une rigidité définie est installé entre une plaque (3, 4) et la cellule de batterie (2).

12. Procédé test d'au moins une cellule de batterie (2) notamment d'une batterie secondaire comportant un dispositif (1) selon l'une des revendications 1 à 11,
- la cellule de batterie (2) est serrée entre une première plaque (3) et une seconde plaque (4) et au moins une plaque (4) est pressée avec une force de compression mécanique (F) définie contre la cellule de batterie (2),
- on mesure au moins une force de réaction (R) entre la cellule de batterie (2) et au moins une plaque (4),
procédé **caractérisé en ce que**
- de préférence simultanément avec la force de réaction (R) on mesure également au moins une variation de l'épaisseur (D) de la cellule de batterie (2).

13. Procédé selon la revendication 12,
**caractérisé en ce que**
on mesure au moins une force de réaction (R) et au moins une variation de l'épaisseur (D) de la cellule de batterie (2) en différents endroits de la cellule de batterie (2).

14. Procédé selon l'une des revendications 12 ou 13,
**caractérisé en ce qu'**
on mesure au moins deux forces de réaction (R) en différents endroits de la cellule de batterie (2).

15. Procédé selon l'une des revendications 12 à 14,
**caractérisé en ce que**
en se fondant sur les résultats des mesures on fait un calcul modélisé avec un modèle de calcul virtuel du dispositif (1) et/ou de la cellule de batterie (2) - de préférence avec identification paramétrique inverse,
- en séparant par filtrage les grandeurs perturbatrices et d'influences du dispositif (1).
